# EUROPEAN PATENT APPLICATION

(11) **EP 4 053 889 A1**
(43) Date of publication of application: **07.09.2022**
(21) Application number: 21160401.2
(22) Date of filing: 03.03.2021
(51) Int. Cl.: H01L 21/761

(54) **ISOLATED WELLS FOR IMPROVED NOISE PERFORMANCE**

(71) Applicant: NXP B.V., 5656 AG Eindhoven (NL)
(72) Inventor: SECAREANU, Radu Mircea, Redhill, Surrey RH1 1QZ (GB)
(74) Representative: Hardingham, Christopher Mark

(57) **Abstract**

An IC die and method are disclosed, the IC having a major surface and comprising a substrate having thereon a plurality of devices; the IC die comprising an isolated region having therein a plurality of the plurality of devices, and comprising at least one region of a first conductivity type and at least one region of a second conductivity type opposite the first conductivity type, the isolated region being isolated from a remainder of the plurality of devices by: a buried layer of a first conductivity type between the isolated region and the substrate, and a perimeter region of the first conductivity type surrounding the isolated region and extending from the first major surface to the buried layer; wherein at least one of the at least one region of the first conductivity type is galvanically connected to a terminal voltage contact, and the perimeter region is galvanically unconnected.

## Description

### Field

The present disclosure relates to isolated wells within semiconductors devices, and in particular to bias connections to improve the noise performance of such devices.

### Background

Noise isolation can be a key performance criterion for some types of semiconductor products, and is particularly so for Integrated Circuits (ICs) which integrate RF functionality with mixed-signal and digital functionality. The range of such ICs is vast and increasing and includes devices for applications as diverse as radar, vehicle-to-vehicle communication, Internet of things, radio, wireless modems, etc. The noise characteristics of products is - or at least it should be - a consideration at all stages of design including technology and process, chip design and circuit layouts, and package- and PCB-level integration.

The present disclosure is primarily concerned with noise considerations from technology, design and modelling perspectives.

One well-known isolation to technique to reduce noise is the use of isolated p-wells (IPWs). Isolated p-wells can be applied to minimise the noise created in one part of the IC from affecting other parts of the IC. However, as with any isolation techniques, IPW has also limitations. The main limitation of IPW is a degradation of noise behaviour at high frequencies, in accordance to the capacitive nature of the IPW isolation.

### Summary

According to a first aspect of the present disclosure, there is provided an integrated circuit, IC, die having a major surface and comprising a substrate having thereon a plurality of devices; the IC die comprising an isolated region having therein a plurality of the plurality of devices, and comprising at least one region of a first conductivity type and at least one region of a second conductivity type opposite the first conductivity type, the isolated region being isolated from a remainder of the plurality of devices by: a buried layer of a first conductivity type between the isolated region and the substrate, and a perimeter region of the first conductivity type surrounding the isolated region and extending from the first major surface to the buried layer; wherein at least one of the at least one region of the first conductivity type is galvanically connected to a supply voltage contact, and the perimeter region is galvanically unconnected. Thus, according to this aspect, it may be possible to reduce noise propagation, that is to say improve the isolation of the well.

In one or more embodiments the first conductivity type is n-type and the second conductivity type is P-type. In such embodiments, the buried layer may alternatively be referred to as a deep n-well or DNW; the perimeter region may alternatively be referred to as an n-well edge ring, and the isolated region may be referred to as an IPW or isolated p-well. The terminal voltage contact in such embodiments is a supply voltage contact, typically Vdd. In other embodiments the first conductivity type is P-type and the second conductivity type is N-type. The terminal voltage contact in such embodiments is generally a ground or local ground voltage contact.

In one or more embodiments each, that is to say all. of the at least one region of a first conductivity type extends to the buried layer. Galvanic connection may refer to a metal or other conductor, or a series of metal or other conductors, which provide a relatively low resistance path for DC current, and thus such a galvanic connection may also be referred to a bias connection.

In one or more embodiments the perimeter region surrounds a perimeter of the buried layer. In other embodiments, the buried layer extends beyond the perimeter of the IPW

In one or more embodiments, the IC die may further comprise a further isolated region. The further isolated region may be remote from the isolated region.

In one or more embodiments, the IC die comprises at least one epitaxial layer being a layer of epitaxial material over the substrate, wherein the buried layer is within the epitaxial layer.

In one or more embodiments, the isolated region comprises an area which is bounded by rectilinear edges, wherein a maximum distance separating any two opposite edges is no greater than 1.5 times a minimum distance separating any two opposite edges.

The isolated region may be rectangular, and may have an aspect ratio which is less than 1.5.

According to a second aspect of the present disclosure, there is provided a method of controlling electrical noise in an integrated circuit, IC, die having a major surface and comprising a substrate having thereon a plurality of devices, the method comprising: providing an isolated region having therein a plurality of devices, and comprising at least one region of a first conductivity type and at least one region plurality of a second conductivity type opposite the first conductivity type, isolating the isolated region being isolated from a remainder of plurality of devices by providing: a buried layer of a first conductivity type, between the isolated region and the substrate, and a perimeter region of the first conductivity type surrounding the isolated region and extending from the first major surface to the region of a first conductivity; galvanically connecting at least one of the at least one region of the first conductivity type to a supply voltage contact and allowing the perimeter region is to electrically float by leaving it unconnected.

According to a third aspect there is provided: a semiconductor circuit comprising a substrate having thereon a plurality of semiconductor devices; the circuit comprising: an isolated region having therein at least one of the semiconductor devices, and having therein at least one region of a first conductivity type and at least one region of a second conductivity type opposite the first conductivity type; a buried layer of a first conductivity type between the isolated region and the substrate, and a perimeter region of the first conductivity type surrounding the isolated region and extending from the first major surface to the region of a first conductivity; wherein the buried layer and the perimeter region are arranged to provide galvanic isolation to the isolated region; wherein at least one of the at least one region of the first conductivity type is galvanically connected to a supply voltage contact, and wherein the perimeter region is galvanically unconnected.

These and other aspects of the invention will be apparent from, and elucidated with reference to, the embodiments described hereinafter.

### Brief description of Drawings

Embodiments will be described, by way of example only, with reference to the drawings, in which
figure 1 illustrates a partial cross section through a conventional IPW;
figure 2 shows a schematic partial plan view schematic of a conventional IPW;
figure 3 shows a noise circuit of an IPW according to one or more embodiments;
figure 4 shows a partial cross section through an IPW according to one or more embodiments,
figure 5 shows a schematic partial plan view schematic of an IPW according to one or more embodiments, and
figure 6 illustrates, in plan view, various shapes of IPWs in accordance with one or more embodiments.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments

### Detailed description of embodiments

At the outset it should be noted that the present disclosure will concentrate on isolated p-wells, since these are overwhelmingly more common than isolated n-wells. However, the disclosure is not limited thereto and the skilled person will appreciate that the disclosure is equally applicable to isolated n-wells. In the case of isolated n-wells, the edge ring discussed below is a p-doped region, the buried layer is a buried p-well, and the terminal voltage is typically a ground voltage.

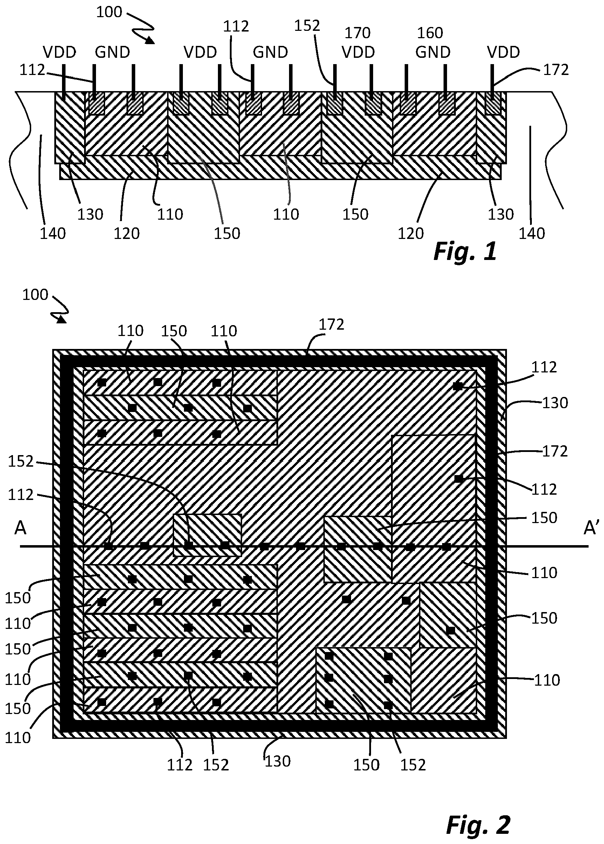

Figure 1 illustrates a partial cross section through a conventional IPW 100, and figure 2 shows a schematic partial plan view schematic of such a conventional IPW. The cross-section of figure 1 may for instance be along line A - A' of figure 2. The p-well consists of P-type semiconductor material 110. The P-type semiconductor material 110 may be epitaxial material grown on top of a substrate (not shown). The epitaxial material may typically be grown directly onto a substrate. The epitaxial material and substrate may be silicon, but the disclosure is not limited thereto, and other materials may be used, such as Silicon-Germanium (SiGe).

Isolation of the p-well is provided by enclosing it (with the exception of the top or major surface of the die) by oppositely doped, in this case N-type, semiconductor material. Thus underneath the p-well is provided a deep n-well layer. This layer is visible at 120 in figure 1, but is hidden in figure 2 by the p-well. The skilled person will be familiar with a deep n-well, which may also be referred to as a DNW, and will be aware of the techniques for providing such a buried layer, which may include ion implantation using a suitable dopant ion such as Phosphorus (P) or Arsenic (As) followed by thermal activation, or diffusion followed by a further diffusion of a P-type dopant in order to over-dope the material which form the well above the deep n-well. The DNW provides vertical isolation between the p-well and the underlying substrate (or epi layer); lateral isolation is provided by an n-well edge ring 130 surrounding the IPW. The n-well edge ring is produced by conventional processing techniques (typically by diffusion or ion implantation, this time of an N-type dopant). It should be noted that the term "edge ring" as used herein refers to the edge of the IPW, and not, in general, the edge of the semiconductor die. Outside the n-well edge ring, is further semiconductor material 140 which may typically be p-well material (not shown).

As shown in figure 1 and figure 2, the material inside the IPW will generally not be entirely P-doped material. Rather, as shown, there may be NMOS devices placed in the p-well pockets 110, and PMOS devices placed in n-Wells 150, that is, areas of N-doped material, located inside the IPW. NMOS devices have body contacts 112, also referred to as p-ties, which are electrically connected to ground 160, via heavily doped P+ contact regions 115 as shown in figure 1 (but omitted from figure 2 so as not to obscure the figure) These contacts are provided at the surface of the device, generally in the "metallisation stack", as will be familiar to the skilled person. Conversely, the PMOS devices in n-wells have body contacts 152, also referred to as n-ties, connected to a supply voltage VDD 170, via heavily doped N+ contact regions 155, again as shown in figure 1 (but omitted from figure 2 so as not to obscure the figure). It will be noted that these regions are shorted through the DNW The n-well edge ring is also tied to, that is to say, biased at, the same supply voltage VDD, through "tie-bar" contacts 172. Generally, the ties-bars 172 around the edge-ring of the p-well are continuous, or nearly so, and low resistivity. In contrast, the body contacts to individual devices inside the IPW, both n-ties to VDD, and p-ties to ground, are small area and of relatively high resistance (the figure schematic only and is not to scale).

An IPW as just described may be used to protect either an Aggressor circuit block or a Sensitive circuit block. As will be familiar to the skilled person, "an Aggressor" circuit block refers to a circuit block that is a source of noise, that is to say, one that generates noise. On the other hand, a "Sensitive" circuit block refers to a circuit block that receives noise, that is to say, one that is sensitive to noise. Each can be of any nature (analog, digital, RF, etc.), depending on the IC chip or circuit functionality. Specifically, when a circuit operates, it inevitably generates a specific noise spectrum or spectra which reflects what the circuit is doing. For example, if a digital circuit switches at 100MHz, the noise spectrum will peak at 100MHz - and include associated harmonics. If we have another block, such as an op-amp for example, and this block has a bandwidth that contains any of these harmonics (such as bandwidth covering 250 to 350MHz, which contains the third harmonic at 300MHz), then the digital circuit is an aggressor for the op-amp, which is a sensitive circuit. Conversely if the bandwidth of the op-amp is 125 to 175MHz, then the digital circuit is harmless to the op-amp (and there is neither an aggressor nor a sensitive block). Note that this example, which is typical, is referenced to spectra, because this is typical and applies to this disclosure; another, though less common, example would be in terms of broad-band magnitude, that is to say noise which creates a time-variant signal that bounces up and down so that at a first time, time-zero, the op-amp sees one noise amplitude, such as 1mV, and at second time, time-one, it creates another noise amplitude, such as 10mV.

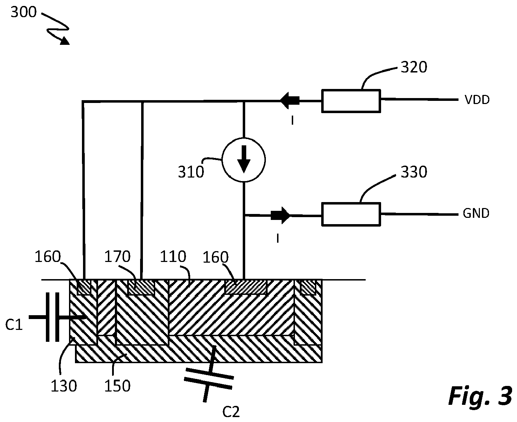

When a circuit in the IPW operates, it generates an internal activity. This is shown schematically in figure 3, which depicts an equivalent noise circuit 300 of an IPW. In its simple form, the internal activity effectively is an AC current source 310 connected between the supply voltage, VDD, and ground, GND, for the circuit, where the AC current, I, of the current source reflects the spectrum or spectra (both magnitude and frequency) generated by the circuit. The circuit includes a first impedance 320 comprising resistive or inductive parasitics of the power line VDD connected to the n-ties 170, and a second impedance 330 comprising the resistive or inductive parasitics of the ground line GND connected to the p-ties 160.

This AC current generates IR noise and L.di/dt noise on the power ground lines, that is to say noise which depends on the routing parasitics on the power and ground lines. As the skilled person will be aware, these parasitics may arise on-chip, or from interactions in the package, PCB, and any coupling capacitor. The details of the parasitics are not particularly germane to the present disclosure. However, at the IPW level, this IR and Ldi/dt noise is injected - through the p-ties for the ground noise, and through the n-ties for the VDD noise. Whereas the noise is sourced or generated in or at the IPW, it will be injected in the substrate bulk to travel towards, and may affect other on-chip circuitry outside of the IPW. The level of noise injection into the substrate bulk is a key metric of an IPW isolation efficiency - the smaller the noise injected into the bulk from the circuit placed in an IPW, the better the IPW isolation efficiency.

It will be appreciated that the noise injected from the IPW into the bulk is capacitive in nature. In the case of VDD noise, there is a single-capacitor characteristic, whilst for the ground noise, there is a double-capacitor capacitor characteristic (a first capacitor being formed between the p-well and the N-type isolation, and the second capacitor being between the N-type isolation and the bulk). It is apparent that the VDD noise injection dominates; being a capacitive injection behaviour with the single capacitor dominating characteristic, it can be shown that the noise injection increases with increasing frequency, at a rate of 20 dB/decade. As shown in figure 3, the single capacitor characteristic has two components: C1, which is the junction capacitance of the n-well edge ring to bulk, and C2, which is the junction capacitance of the buried layer DNW to bulk. For any given technology node, C1 is always larger than C2, since the edge-ring is doped significantly higher, typically by 1-2 orders of magnitude, than the buried layer.

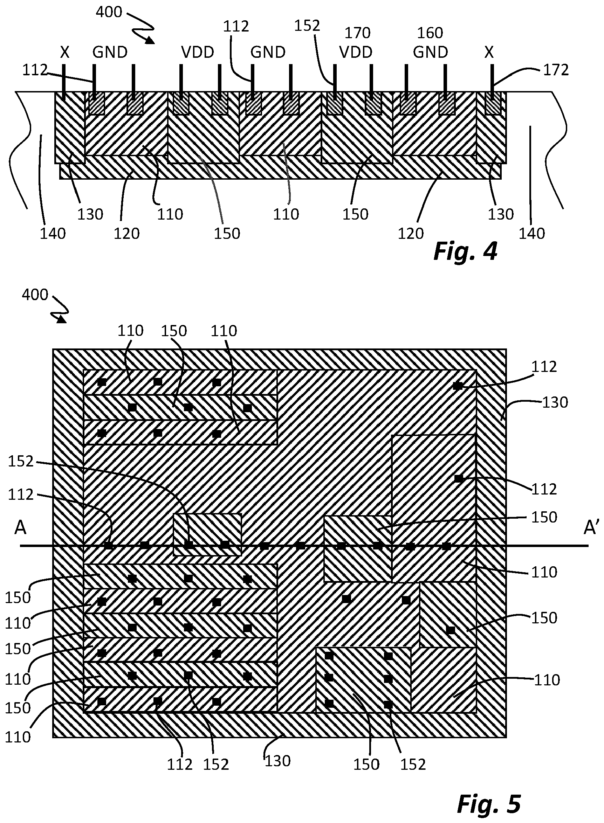

Figure 4 shows a partial cross section through an IPW according to one or more embodiments, and figure 5 shows, schematically, a corresponding plan view. Similar to the IPW shown in figures 1 and 2, the p-well consists of P-type semiconductor material 110. Isolation of the p-well is provided by enclosing it (with the exception of the top or major surface of the die) by oppositely doped, in this case N-type, semiconductor material, comprising an edge ring 130 and a buried layer 120, again in this case of N-Type material. Outside of the N well edge ring, is further semiconductor material 140 which may typically be p-well material (not shown). Again, similar to figure 1, inside the IPW there may be N-doped regions or n-wells 150 having PMOS devices therein and P doped pockets 10 having N-MOS devices therein. The n-well regions within the IPW are again connected to a supply voltage VDD 170 (via more highly doped contact regions) and the P doped pockets are connected to ground 160 (again, via high doped contact regions). However, in this case the edge ring 130 of n-doped material around the perimeter of the IPW is not connected to the supply voltage. Rather, the edge ring is not connected to any voltage, but is allowed to float.

An effect of allowing the edge ring to float is to decouple the two capacitive elements C1 and C2 mentioned above, both of which reflect VDD line noise. This can reduce the noise injection through C1. This may be beneficial for two reasons. Firstly, consider that outside the IPW is usually p-doped material of another p-well. The doping of such a p-well is typically largest at the silicon surface - a major surface of the device- and falls to the doping level of p-epitaxial material with increasing depth (typically corresponding to a single or multi- diffusion profile or one or more ion implantation profiles). Noise injected in a higher doped area propagates, or travels, further on-chip since the resistance encountered or seen by the noise is smaller. Therefore it is beneficial to reduce or minimise this noise injection (via C1). Secondly as already mentioned, C1 is always higher than C2, and injection of noise increases with increasing capacitance. Decoupling, and thereby reducing the VDD noise from begin injected through C1 can thus reduce the overall noise injection.

By disconnecting the edge ring from the supply voltage VDD, the capacitances C1 and C2 may be effectively decoupled. It will be appreciated that both the buried layer DNW, and the n-well edge ring will remain biased, through their connection to the internal n-wells 150, which themselves are still connected to the supply voltage. This bias is required to be retained in order to ensure the integrity of the isolation of the IPW.

Disconnecting the edge ring from VDD has only a small effect on noise injection through the NPW to the bulk through C2: the injection through C2 is undisturbed since the noise seen from VDD lines remains the same as propagated through the internal n-wells. There is generally a small difference because of fringe effect arising from reduced injection efficiency from the floating edge-ring.

Because the edge ring is no longer connected to VDD, the VDD noise present in the IPW is at the internal n-wells. In order for this noise to be injected through C1, it would have to overcome the internal IPW parasitics existing in a path between the vertical internal n-wells, through the horizontal buried layer, and to the vertical edge of the n-well edge ring. These parasitics are relatively large, which significantly reduces the noise at the edge ring and the corresponding noise injection through the capacitance element C1. It will be noted that the parasitics are principally resistive in character, and in particular have relatively high resistance along the horizontal buried layer DNW 130, due to the relatively low doping of that buried layer. It will further be appreciated that the resistance increases with increasing separation between the internal n-wells and the n-well edge ring. Increased separation may be achieved in practice by ensuring that close to the edge ring within the IPW, are positioned mainly or entirely NMOS transistors, thereby reducing, minimising or even avoiding completely, a positioning of internal n-wells close to the edge ring.

Simulations have been performed for a sample design block. Disconnection of the IPW n-well edge ring from the supply voltage, without any other optimisation, was shown to increase the noise efficiency of the IPW by 3 to 5 dB, for frequencies higher than 500MHz, with variations depending on sizing and other variables.

It will further be appreciated that the capacitance C1 may be further reduced relative to C2 by appropriate optimisation of the ratio of the area to the perimeter of the IPW. In general, it is desirable to reduce the perimeter relative to the area. For an IPW which is rectangular, or nearly rectangular, this results in optimal designs of the IP W being generally square, or nearly square, rather than high aspect ratio - that is to say being a rectangular shape which is long and thin. A mathematician will be aware that the completely optimal - that is to say minimum - ratio of perimeter to area is achieved by a circular design; however generally in the semiconductor industry rectangular blocks are preferred, although it may be possible to introduce tracks or design blocks or shapes which include 45° angles in some applications. In such design scenarios it may be preferred to optimise the design such that it is, or is close to, a regular octagon.

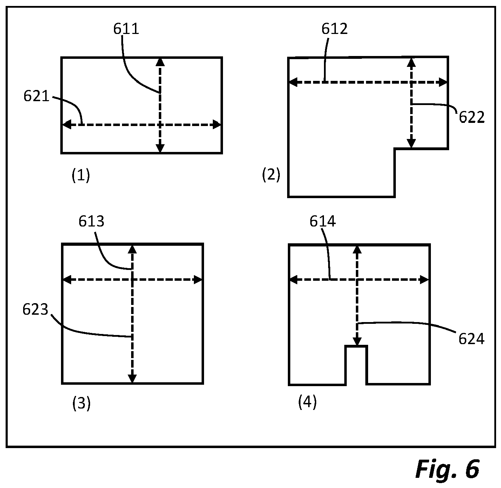

This is illustrated schematically in figure 6. Figure 6 shows, in plan view, 4 IPWs, each of which are generally rectangular in shape, and a suitable to ensure good isolation: shape (1) is a simple rectangle, having a width 611 and length 621. The aspect ratio is relatively low - that is to say the ratio of length to width is less than 1.5. Shape (2) is a rectangular shape with a corner cut-out. The edges are generally rectilinear, that is to say at 90° to each other, and in this type of generally rectangular shape, it is desirable that the ratio between the maximum distance between opposite sides, shown at 612, and the minimum distance between opposites sides, shown at 622, is kept relatively low, such as below 1.5. Shape (3) shows an optimum configuration for a simple rectangle, wherein the width 613 is equal to the length 603. In this case the aspect ratio is equal to 1. Finally, shape (4) shows a similar design which is generally square but includes a cut-out as shown. In this case it is still desirable that the minimum maximum distance between two opposite sides, shown here at 614, is no greater than 1.5 times a minimum distance between two opposite sides, shown here to the cut-out, at 624.

From reading the present disclosure, other variations and modifications will be apparent to the skilled person. Such variations and modifications may involve equivalent and other features which are already known in the art of noise isolation, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, and reference signs in the claims shall not be construed as limiting the scope of the claims.

## Claims

1. An integrated circuit, IC, die having a major surface and comprising a substrate having thereon a plurality of devices;
the IC die comprising
an isolated region having therein a plurality of the plurality of devices, and comprising at least one region of a first conductivity type and at least one region of a second conductivity type opposite the first conductivity type, the isolated region being isolated from a remainder of the plurality of devices by:
a buried layer of a first conductivity type between the isolated region and the substrate, and a perimeter region of the first conductivity type surrounding the isolated region and extending from the first major surface to the buried layer;
wherein at least one of the at least one region of the first conductivity type is galvanically connected to a terminal voltage contact, and the perimeter region is galvanically unconnected.

2. An IC die according to claim 1, wherein the first conductivity type is N-type and the second conductivity type is P-type, and wherein the terminal voltage is a supply voltage.

3. An IC die according to claim 1, wherein the first conductivity type is P-type and the second conductivity type is N-type, and wherein the terminal voltage is a ground voltage.

4. An IC die according to claim 1 or 2, wherein at each of the at least one region of a first conductivity type extends to the buried layer.

5. An IC die according to any preceding claim, wherein at each of the at least one region of the second conductivity type is galvanically connected to a ground voltage contact.

6. An IC die according to any preceding claim, wherein the perimeter region surrounds a perimeter of the buried layer.

7. An IC die according to any preceding claim, further comprising a further isolated region.

8. An IC die according to claim 7, wherein the further isolated region is remote from the isolated region.

9. An IC die according to any preceding claim, comprising at least one epitaxial layer being a layer of epitaxial material over the substrate, wherein the buried layer is within the epitaxial layer.

10. An IC die according to any previous claim wherein the isolated region is bounded by rectilinear edges, wherein a maximum distance separating any two opposite edges is no greater than 1.5 times a minimum distance separating any two opposite edges.

11. An IC die according to claim 10, wherein the isolated region is rectangular, and has an aspect ratio which is less than 1.5.

12. A method of controlling electrical noise in an integrated circuit, IC, die having a major surface and comprising a substrate having thereon a plurality of devices;
the method comprising:
providing an isolated region having therein a plurality of devices, and comprising at least one region of a first conductivity type and at least one region plurality of a second conductivity type opposite the first conductivity type,
isolating the isolated region being isolated from a remainder of plurality of devices by providing:
a buried layer of a first conductivity type, between the isolated region and the substrate, and a perimeter region of the first conductivity type surrounding the isolated region and extending from the first major surface to the region of a first conductivity;
galvanically connecting at least one of the at least one region of the first conductivity type to a supply voltage contact and
allowing the perimeter region is to electrically float by leaving it unconnected.
